# EUROPEAN PATENT APPLICATION

(11) **EP 0 531 232 A2**
(43) Date of publication of application: **10.03.1993**
(21) Application number: 92420276.5
(22) Date of filing: 13.08.1992
(51) Int. Cl.: H01L 21/20

(54) **High durability mask for use in selective area, epitaxial regrowth of GaAs**

(30) Priority: 26.08.1991 US 749768
(71) Applicant: EASTMAN KODAK COMPANY, Rochester, New York 14650-2201 (US)
(72) Inventor: Franke, Hans G., c/o EASTMAN KODAK COMPANY, Rochester New York 14650-2201 (US); Prince, Eric T., c/o EASTMAN KODAK COMPANY, Rochester New York 14650-2201 (US); Lawrence, David J., c/o EASTMAN KODAK COMPANY, Rochester New York 14650-2201 (US)
(74) Representative: Parent, Yves

(57) **Abstract**

A durable mask is described which enables the fabrication of deep channels in GaAs suitable for refilling by Liquid Phase Epitaxy (LPE). The deep channels are fabricated by dry etch processing in chlorine containing ambients with sidewalls which do not undercut the mask. The mask consists of an amorphous form of carbon which may contain incorporated hydrogen. The mask which eliminates problems associated with selective area, epitaxial regrowth of GaAs employing mask undercut profiles can be applied, patterned, and removed through dry processing techniques.

## Description

### CROSS-REFERENCE TO RELATED APPLICATION:

Reference is made to commonly assigned copending application Serial No. 679,843, filed April 3, 1991 entitled "High Durability Mask for Dry Etch Processing of GaAs" by H. G. Franke and E. T. Prince, the teachings of which are incorporated herein.

### Field of the Invention:

This invention relates to the use of a highly durable mask for the protection of desired regions of GaAs during the fabrication of features such as channels by dry etch processing in chlorine containing ambients. More specifically, this invention relates to the use of a highly durable carbon mask to fabricate channels in GaAs with sidewalls which do not undercut the mask. Channels of this type are suitable for selective area, epitaxial regrowth.

### Background of the Invention:

In the fabrication of opto-electronic integrated circuits on substrates of GaAs features such as channels are often required to produce regions suitable for selective area, epitaxial regrowth. Selective areas of epitaxially regrown GaAs are useful for the fabrication of specific device elements, e.g., emitters, detectors and waveguides. (GaAs as used herein includes all compounds, crystalline and polycrystalline, doped or undoped, containing gallium and arsenic with or without additional elements.) Features such as channels suitable for the epitaxial regrowth of GaAs must be formed through etch processes which do not undercut the mask. Wet processes are unsuitable as they provide features which are isotropically or crystallographically etched with mask undercut. Dry processes, on the other hand, provide features with sufficient anisotropy which do not undercut the mask.

The majority of etch processes which provide anisotropy in GaAs are dry, ion-based techiques which utilize chemistry to provide some form of reactive assistance. The most common of the dry etch processes include: Reactive Ion Etching (RIE), Reactive Ion Beam Etching (RIBE), and Ion Beam Assisted Etching (IBAE) [also known as Chemically-Assisted Ion Beam Etching (CAIBE)]. The chemistry utilized by these techniques for reactive assistance enhances etch rates, forms volatile etch products, and minimizes (relative to non-chemically assisted processes) damage to the GaAs surface by energetic ions, neutrals, and/or radicals. In the dry etch processing of GaAs, ambients containing chlorine (atoms, molecules, neutrals, radicals) have been found most useful for providing the necessary reactive assistance.

Some form of mask is required to protect desired regions when using dry techniques to etch substrates of GaAs. Durable masks are often of particular value. The term "durable" as used herein defines the resistance of the mask to erosion during an etch process. An ideal mask is durable to the extent it will not erode or change form during an etch process. For a mask to exhibit significant durability in the dry etch processing of GaAs, the ratio of the etch rate of the GaAs to that of the mask, i.e., the selectivity of the etch, must be high. Masks of materials of low durability are unsuitable for several reasons. First, the edge quality of etch features decreases as mask thickness increases. Second, mask features of dimensions smaller than the thickness of the mask are unstable and can break away or shift position during processing. Finally, mask erosion especially of edges can redeposit mask material into unwanted regions and degrade overall etch quality and uniformity.

In the dry etch processing of GaAs using chlorine for chemical assistance, few materials are known which when applied as thin layers (ca. 0.1 um) offer the durability to survive an etch of from a few to many um. Metals such as nickel (with titanium underlayer) and chromium and salts such as aluminum fluoride and strontium fluoride have been used with varying degrees of success. Wet techniques are frequently required to follow the dry etch processes to effect complete removal of these materials. What are needed are masks of high durability which are convenient to apply, pattern, and remove.

### SUMMARY OF THE INVENTION:

An object of this invention is to provide a durable mask for the dry etch processing of GaAs by chlorine containing ambients. This object is achieved by a method of forming a highly durable mask for use in the dry etch processing of GaAs, comprising the steps of:
(a) providing a layer of amorphous carbon over the GaAs which is resistant to attack by chlorine on GaAs;
(b) forming openings in the amorphous carbon layer to expose the GaAs or suitable overlayer by dry processing to form an amorphous mask;
(c) dry etch processing of GaAs in chlorine containing ambients through the opening in the mask;
(d) forming features with sidewalls which do not undercut the amorphous carbon mask;
(e) regrowing of GaAs in such features; and
(f) removing the mask.

The mask must permit features such as channels to be etched in GaAs which are suitable for selective area, epitaxial regrowth, i.e., the sidewalls of the etch must not undercut the mask. Quite unexpectedly, we have discovered that a mask formed of amorphous carbon is highly resistant to attack by chlorine during dry etch processing in chlorine containing ambients. This mask permits the etching of features such as channels in GaAs with no mask undercut. The amorphous carbon can be applied and removed by dry processing techniques.

A feature of this invention is that no wet etch steps are required following lithographic patterning.

### BRIEF DESCRIPTION OF THE DRAWINGS:

Fig. 1 (a-j) are sectional views not to scale illustrating various steps in the preferred method of forming and removing the highly durable mask resistant to attack by chlorine;
Fig. 2 is an example of a typical temperature vs time curve for the method of regrowing epitaxial GaAs by Liquid Phase Epitaxy (LPE) in channels prepared through dry etch processing using the highly durable mask;
Fig. 3 is a sectional view illustrating the epitaxial regrowth of GaAs by LPE in channels prepared without mask undercut; and
Figs. 4a and 4b are sectional views not to scale of channels in GaAs illustrating mask undercut and the dependence on crystallographic orientation introduced by wet etch processes.

### DETAILED DESCRIPTION OF THE PREFERRED EMBODIMENT:

A mask of amorphous carbon can be prepared by plasma-assisted CVD, i.e., through the plasma decomposition of a hydrocarbon. A wide range of process conditions can be used.
Alternative techniques to deposit this material can be used as well. These include variations of the plasma-assisted CVD technique, glow discharge (rf and dc) sputter deposition, single and dual ion beam sputter deposition, reactive ion beam deposition, evaporation, and ion plating. Depending on the deposition technique selected, the chemical and physical properties of the carbon mask may vary; the chemical properties from amorphous carbon (a-C) to hydrogenated amorphous carbon (a-C:H), the physical properties from diamond-like to graphite-like.

Amorphous carbons which serve as highly durable masks are determined easily through routine examination using, for example, scanning electron microscopy (SEM), and experiments such as those described in the subsequent example. To be considered highly durable, the ratio of the etch rate of GaAs to that of the mask should exceed (50:1) and more typically, (75-100:1). The ambient under which this durability is established may include chlorine containing gases or gas mixtures other than those given by the examples, e.g., BCl3, BCl3/Ar, etc., as long as the ambient is a suitable ambient for the dry etching of GaAs.

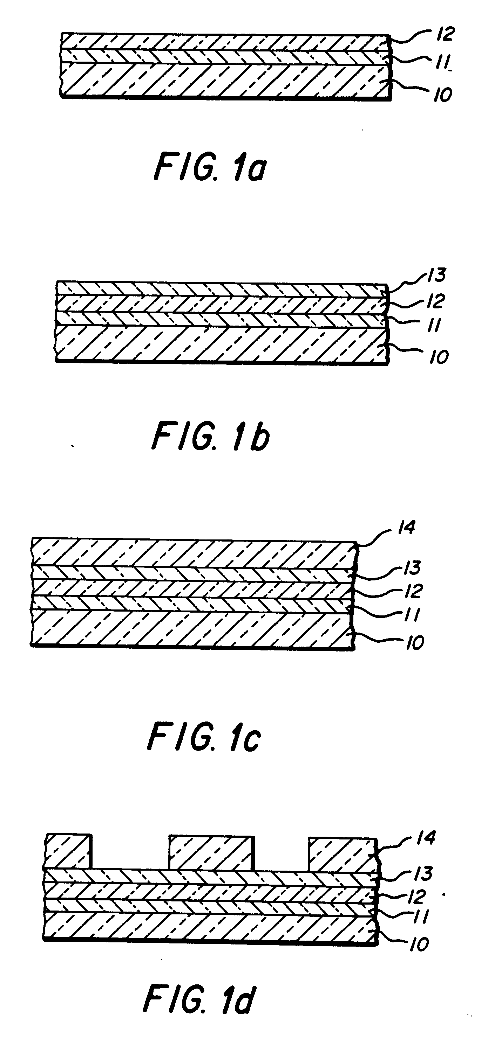

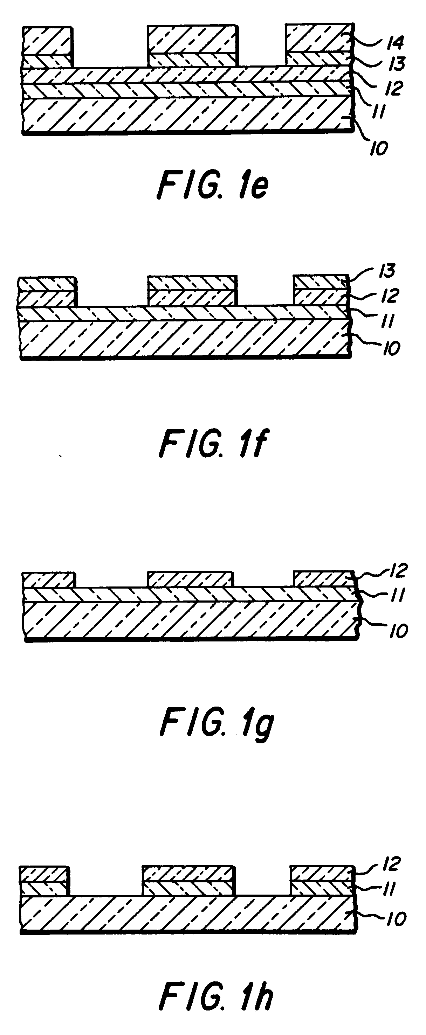

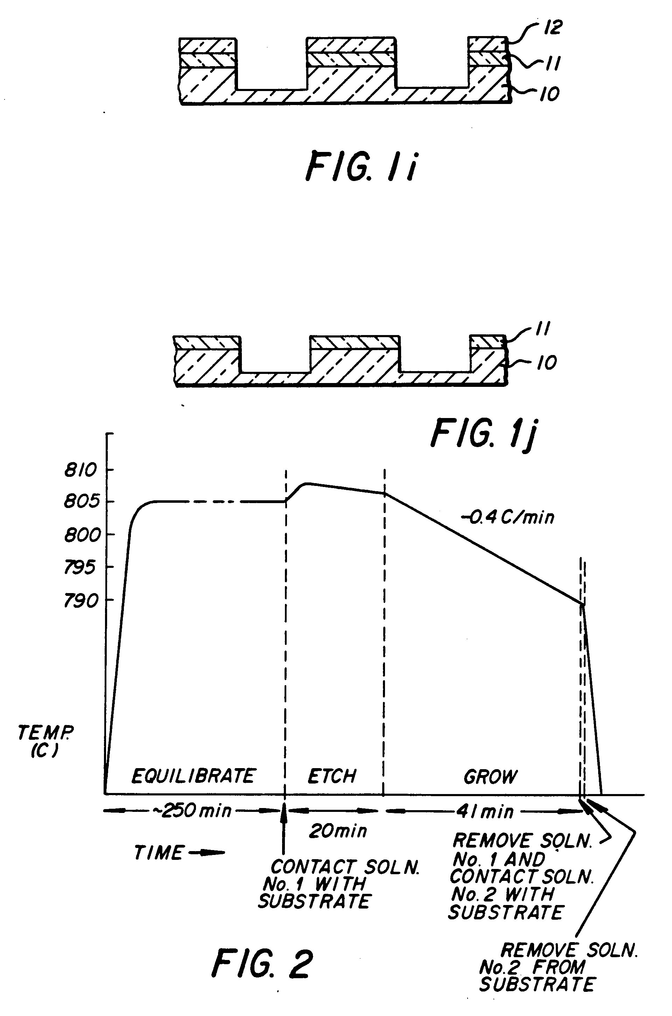

As shown in Fig. 1a, a layer of amorphous carbon 12 is deposited on a substrate 10 of GaAs which contains an overcoating 11 of a material such as SiO2, Si3N4 or amorphous silicon. An amorphous material is preferred for layer 11 to prevent transfer of grain boundary features. This overlayer provides an adhesion layer for the amorphous carbon, protects the surface of the GaAs from damage by ion bombardment during the deposition of the amorphous carbon, and serves as a mask for the epitaxial regrowth of GaAs by LPE. As shown in Fig. 1b, a thin layer 13 of a material such as SiO2, Si3N4 or amorphous silicon, is applied over the amorphous carbon layer. Again, an amorphous arterial is preferred for this layer to prevent transfer of grain boundary features. A layer 14 of a lithographically patternable material, e.g., photoresist or an electron beam sensitive resist, is then applied to the surface of layer 13 as shown in Fig. 1c. Layer 14 is then exposed and developed according to accepted practices to provide a pattern as shown in Fig. 1d. Next a Reactive Ion Etch (RIE) step is used with an appropriate gas chemistry to selectively etch layer 13 through the exposed regions of pattern in layer 14 as shown in Fig. 1e. Alternative dry etch techniques may be substituted for any of the RIE steps specified in this description whenever more convenient. If layer 13 is composed of SiO2 or amorphous silicon a freon/oxygen mixture such as CF4/02 (96 vol% CF4, 4 vol% O2) can be used to selectively remove this layer by RIE. Another dry etch by RIE is then performed using oxygen (O2) to selectively transfer the mask pattern in layer 13 through the amorphous carbon layer 12 to provide openings. This etch may also be used to remove the lithographically patternable layer 14 (Fig. 1f). The sample is then dry etched by RIE using a suitable selective gas to remove the remaining layer 13 pattern (Fig. 1g) and layer 11 (Fig. 1h) in the patterned openings in the carbon mask. At this point the mask processing is complete. With GaAs exposed in the patterned openings of the mask the wafer is ready for dry etching in a chlorine containing ambient. Following transfer of the pattern into GaAs (Fig. 1i), the amorphous carbon layer 12 is removed by RIE using O2 (Fig. 1j).

The GaAs wafer with layer 11 and etched channels (which do not undercut this layer) is loaded in an LPE growth system. A typical profile of the temperature vs time for an LPE growth process is shown in Fig. 2. The temperature of the GaAs is elevated to a suitable starting temperature (typically between 700-900 degrees C). The GaAs is brought into contact with a saturated Ga-As solution which may or may not contain Al and/or a suitable dopant. The temperature is raised slightly above the starting temperature (if desired) to dissolve away material in the channels which may have been damaged through dry etch (RIE) processing. This procedure may provide a slight mask undercut which will not adversely affect the following refill process. After a period of time at this temperature (somewhere between 0.5-30 minutes, typical) the temperature is lowered at a controlled rate (within the range 0.05-2 degrees C/min, typical) to fill the channels with epitaxial GaAs. When desired the dissolution/growth solution may be replaced near the end of this process by a second solution to produce a thin protective `cap' layer. The LPE process is completed by cooling the GaAs to room temperature. If desired this process can be extended to the growth of multiple layers. It will be understood to those skilled in the art that the regrowing step may also be accomplished by means other than LPE, such as for example vapor plase epitaxy (VPE) organometailic vapor phase epitaxy (OMVPE), molecular beam epitaxy (MBE) or various combinations thereof.

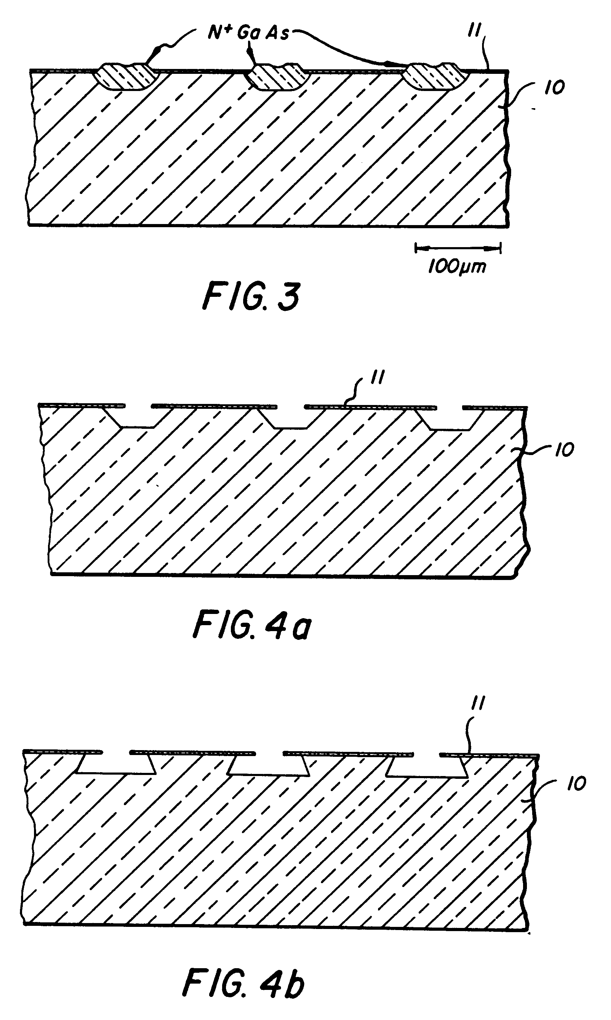

A cross section of the wafer after the channels have been filled by LPE with the `cap' layer removed is shown in Fig. 3. In this figure the channels are overfilled. By controlling the growth time in the LPE process, however, the degree to which the channels are filled can be controlled. The channels in this figure can be `deep' with no mask undercut due to the durability of the carbon mask. (To qualify the term `deep,' a mask of amorphous carbon 1.0 um thick, for example, is capable of protecting underlying materials during etching of GaAs to depths of 100 um.) The channels retain a nearly flat bottom as shown.

Cross sections of a wafer with wet chemically etched channels are shown in Figs. 4a and 4b. The features in these figures illustrate the dependence on crystallographic orientation typical of wet etching processes in GaAs. To compensate for mask undercut the opening in mask layer 11 must be substantially narrower than the width of the desired feature. The undercut in wet etching is roughly equal to the etch depth. Small openings in mask layer 11 frequently prevent wetting, nucleation and growth during LPE so that refill of channels cannot be obtained. Even if nucleation and growth is achieved, the mass transport of As through the growth solution to the growing surface occurs through narrow openings. This provides a refill which is extremely non-planar with voids under the mask edges (layer 11).

### EXAMPLE

An example is presented here which describes the use of LPE to fill channels in GaAs formed through dry etch processing in a chlorine containing ambient using the highly durable carbon mask. The means used to pattern the carbon mask in this example deviate from the means described in the preferred embodiment only for reasons of convenience and in no way affect the essence of the example.

In this example a layer of amorphous carbon of thickness 0.25 um was deposited onto a layer of CVD deposited SiO2 of thickness 0.21 um on a GaAs substrate. The amorphous carbon was deposited by the plasma-assisted CDV technique onto an rf powered electrode upon which the GaAs was placed at a self-bias voltage of 1600 V and a methane pressure of 16 mTorr. An appropriate pattern in photoresist was applied over the amorphous carbon using an Imidazole-based photoresist lift-off process. Aluminum was deposited to a thickness of 0.1u over the pattern. After completing the metal lift-off sequence, i.e., removal of the photoresist, the pattern in the Aluminum was transferred to the amorphous carbon layer by RIE at 300 W in O2 at a pressure of 40 mTorr. RIE was again used to transfer the pattern through the SiO2 layer at 300 W in CF4/02 (96 vol% CF4, 4 vol% O2) at a pressure of 100 mTorr. A wet etchant was next used to strip the aluminum from the sample. Channels 20 um deep were dry etched through openings in the amorphous carbon and SiO2 mask layers into the GaAs substrate by RIE at 330 W in Cl2/Ar (25 vol% Cl2, 75 vol% Ar) at a pressure of 30 mTorr. Under these conditions the selectivity, i.e., the ratio of the etch rate of the GaAs to that of the amorphous carbon, was found to exceed 100/1. RIE at 300 W in O2 at 40 mTorr was used to remove the remaining amorphous carbon.

The process of regrowing GaAs in the dry etched channels through LPE began with a brief (ca. 10 s) chemical etch in a slow etchant consisting of 5 ml of 30% NaOH, 5 ml of 30% H2O2 and 250 ml H2O to clean the sample. The sample was loaded into the LPE growth system. The temperature as a function of time for the process is shown in Fig. 2. LPE was performed at a starting temperature of 805 degrees C. The semi-insulating GaAs wafer with channels was brought into contact with a tin-doped, saturated Ga-As solution (solution no. 1 in Fig.2). The temperature was then raised to 807.5 degrees C to remove by dissolution material in the channels which may have been damaged by the RIE processing. After 20 minutes, the temperature was decreased at a rate of 0.4 degree C/min. Cooling was continued for 40 minutes which resulted in the growth of n-type (tin-doped, n=1 x 10¹⁸/cm³) GaAs in the channels of the semi-insulating GaAs substrate. The dissolution/growth solution (solution no. 1) was then removed from the substrate and a second solution (solution no. 2) was put in contact with the wafer for one minute, while cooling continued. This formed a thin protective `cap' layer. The composition of the second solution (solution no. 2) was appropriate for the growth of undoped Al_{0.8}Ga_{0.2}As. The second solution as shown in FIG. 2 was removed from the wafer and the system was cooled to room temperature. The `cap' layer was removed in concentrated HCl. In cross - section the channels were filled successfully (actually overfilled) and retain a nearly flat bottom as shown in Fig. 3.

The invention has been described in detail with particular reference to a certain preferred embodiment thereof, but it will be understood that variations and modifications can be effected within the spirit and scope of the invention.

## Claims

1. A method of forming a highly durable mask for use in the dry etch processing of GaAs, comprising the steps of:
(a) providing a layer of amorphous carbon over the GaAs which is resistant to attack by chlorine on GaAs;
(b) forming openings in the amorphous carbon layer to expose the GaAs or suitable overlayer by dry processing to form an amorphous mask;
(c) dry etch processing of GaAs by chlorine containing ambients through the opening in the mask;
(d) forming features with sidewalls which do not undercut the amorphous carbon mask;
(e) regrowing of GaAs in such features; and
(f) removing the mask.

2. The method of claim 1 wherein the amorphous carbon contains incorporated hydrogen.

3. The method of claim 1 wherein the mask is removed by dry processing.

4. The method of claim 1 wherein the regrowing step is by Liquid Phase Epitaxy (LPE).

5. A durable mask for use in the dry etch processing of GaAs by chlorine containing ambients, comprising:
a layer of amorphous carbon over the GaAs resistant to attack by chlorine and having openings which expose the GaAs so that it can be etched by chlorine.
